Europäisches Patentamt

European Patent Office

Office européen des brevets

(11) Veröffentlichungsnummer: **0 528 068 A1**

## EUROPÄISCHE PATENTANMELDUNG

(21) Anmeldenummer: **91113941.8**

(51) Int. Cl.5: **H03K 19/003**

(22) Anmeldetag: **20.08.91**

(43) Veröffentlichungstag der Anmeldung:
**24.02.93 Patentblatt 93/08**

(84) Benannte Vertragsstaaten:
**AT BE CH DE FR GB IT LI NL SE**

(71) Anmelder: **SIEMENS AKTIENGESELLSCHAFT**
**Wittelsbacherplatz 2**
**W-8000 München 2(DE)**

(72) Erfinder: **Hofmann, Rüdiger, Dr. rer. nat.**
**Fürstenfelder Weg 12**
**W-8031 Gilching(DE)**

(54) **IC-Inverter- bzw.-Bufferschaltung.**

(57) Zur Vermeidung von Umschalt-Stromspitzen und Egalisierung der Signalflanken bei CMOS-Bufferschaltungen wird ein für die vorgesehene Last erforderliches Verhältnis von Transistorweite zu Transistorlänge der CMOS-Transistoren durch Parallelschaltung von N Buffern ($B_I$-$B_N$) mit um den Faktor I/N kleinerem W/L-Verhältnis realisiert. Die einander paralellgeschalteten Buffer ($B_I$-$B_N$) sind tristatefähig und werden von einer Laufzeit-Steuerkette (Jo-I) bei jeder Zustandsänderung des Schaltungseingangssignals unverzüglich kurzzeitig gesperrt und sukzessive wieder entriegelt.

FIG 3

EP 0 528 068 A1

In hochintegrierten und schnell schaltenden CMOS-Bausteinen tritt generell das Problem auf, daß während Zustandsänderungen von Takt- bzw. Ausgangsbuffern, d. h. im Zeitbereich der Schaltflanken, hohe, impulsartige Stromspitzen in den über die Betriebspotentialanschlüsse verlaufenden Stromkreisen auftreten.

Da die beiden Betriebspotentiale $U_{DD}$ (positives Betriebspotential) und $U_{SS}$ (Masse) über Zuleitungswiderstände und Zuleitungsinduktivitäten an die Buffer-Transistoren gelangen, sind dabei mitunter erhebliche Einbrüche der an den Transistoren selbst verfügbaren Betriebsspannungen bzw. Betriebspotentiale zu erwarten.

Merklich verschärft wird dieses Problem noch dadurch, daß die Höhe solcher Stromspitzen bei CMOS-Bausteinen sehr stark von deren Betriebsbedingungen abhängt: Arbeitet ein CMOS-Baustein beispielsweise unter sog. "Best-Case-Bedingungen" wie niedriger Chiptemperatur, hohem Betriebspotential $U_{DD}$ (+ 10 %) und "strong" (= schnellen) Parametern, so sind die Stromspitzen etwa viermal höher als bei "Worst-Case-Bedingungen" wie hoher Chiptemperatur, niedrigem Betriebspotential $U_{DD}$ (- 10 %) und "weak" (langsamen) Parametern. Der Best-Case-Fall stellt somit bezüglich der zu erwartenden Spannungseinbrüche den ungünstigsten Fall dar.

Um dem zu begegnen, kann man die Anzahl der $U_{DD}$- und $U_{SS}$-Speisepotentialzuleitungen bzw. die Größe der chipinternen Bufferkapazität zwischen $U_{DD}$ und $U_{SS}$ auf diesen ungünstigsten Fall hin dimensionieren, was beispielsweise bis zu 25 $U_{DD}$- und $U_{SS}$-Zuleitungspaare notwendig macht.

Neuere Entwicklungen mildern den ungünstigen Best-Case-Fall mit Hilfe von zusätzlichen Transistoren im Speisestromkreis von CMOS-Inverterbzw. -Bufferschaltungen, die an ihren Gate-Elektroden mit Steuersignalen beaufschlagt sind, so daß in den CMOS-Inverter- bzw. -Bufferschaltungen die Flankensteilheit und in Verbindung damit auch die Stromspitzen in bestimmten Grenzen gehalten werden (US-A-4 791 326). Auf diese Weise läßt sich indessen lediglich der über eine ausgangsseitige kapazitive Belastung fließende Umladestrom merklich begrenzen, während der während eines Umschaltvorganges im Inverter bzw. Buffer selbst vom einen Betriebspotentialanschluß ($U_{DD}$) zum anderen Betriebspotentialanschluß ($U_{SS}$) kurzzeitig fließende Kurzschlußstrom nur wenig reduziert wird.

Die Erfindung zeigt nun einen Weg, den aufgezeigten Problemen wirksamer zu begegnen.

Die Erfindung betrifft eine IC-Inverter- bzw. -Bufferschaltung in CMOS-Technologie mit der Reihenschaltung zweier zueinander komplementärer Feldeffekttransistoren, deren jeweils eine, der Reihenschaltung abgewandte Hauptelektrode mit dem einen bzw. dem anderen Anschluß der Betriebsspannungsquelle verbunden ist, zu deren miteinander verbundenen Steuerelektroden der Schaltungseingang führt und deren miteinander verbundene andere Hauptelektroden zum Schaltungsausgang führen; diese Schaltung ist erfindungsgemäß dadurch gekennzeichnet,

daß ein für die vorgesehene Last erforderliches Verhältnis von Transistorkanalweite zu Transistorkanallänge der Komplementär-Transistoren durch Parallelschaltung von N Inverter- bzw. Buffer-Schaltungen mit um den Faktor 1/N kleinerem Verhältnis von Transistorkanalweite zu Transistorkanallänge der Komplementär-Transistoren realisiert wird,

daß in dieser Weise N tristatefähige Inverter- bzw. Buffer-Schaltungen einander parallelgeschaltet sind, die jeweils von einem zusätzlichen Steuereingang her zu sperren bzw. zu entriegeln sind,

und daß die zusätzlichen Steuereingänge dieser N tristatefähigen Inverter- bzw. Bufferschaltungen mit Abgriffen einer Laufzeit-Steuerkette verbunden sind, von der her die N Inverter- bzw. Buffer-Schaltungen bei jeder Zustandsänderung des Schaltungseingangssignals unverzüglich kurzzeitig gesperrt und sukzessive wieder entriegelt werden.

Die Erfindung bringt den Vorteil mit sich, sowohl selbst kurzzeitige Kurzschlußströme in den Inverter- bzw. -Bufferstufen vermeiden als auch die Ausgangssignalflanken unabhängig von den Betriebsbedingungen (Best Case, Worst Case) annähernd gleichförmig und in zumindest angenähert gleicher Zeitlage ausbilden zu können; die Laufzeit-Steuerkette kann dabei vorteilhafterweise von allen auf einem Chip befindlichen, gemäß der Erfindung realisierten Inverter- bzw. Bufferschaltungen gemeinsam benutzt werden.

In weiterer Ausgestaltung der Erfindung können die zusätzlichen Steuereingänge der Inverterbzw. -Bufferschaltungen jeweils an ein Antivalenzglied oder Äquivalenzglied angeschlossen sein, das mit seinem einen Eingang an einem entsprechenden Abgriff einer eingangsseitig am Schaltungseingang liegenden Laufzeitkette und mit seinem anderen Eingang am Schaltungseingang liegt; die Laufzeitkette kann in weiterer Ausgestaltung der Erfindung durch eine Kettenschaltung von ihrerseits in ihrer Flankensteilheit gesteuerten CMOS-Invertern gebildet sein.

Um die Sicherheit in der Vermeidung jeglicher Kurzschlußströme noch zu erhöhen, kann in weiterer Ausgestaltung der Erfindung zwischen den Schaltungseingang und die miteinander verbundenen Steuerelektroden der Komplementär-Transistor der einzelnen Inverter bzw. Buffer jeweils noch eine Laufzeitschaltung eingefügt sein, wobei diese in weiterer Ausgestaltung der Erfindung durch den ersten Teil der zuvor genannten Laufzeitkette gebildet sein kann.

Weitere Besonderheiten der Erfindung werden aus der nachfolgenden Beschreibung anhand der Zeichnungen ersichtlich. Dabei zeigt

FIG 1 eine konventionelle CMOS-Inverter- bzw. -Bufferschaltung und ein ihr entsprechendes Schaltungssymbol; dazu verdeutlicht

FIG 2 die Kanalweite und Kanallänge eines Feldeffekttransistors.

FIG 3 zeigt ein Ausführungsbeispiel einer CMOS-Inverter- bzw. -Bufferschaltung gemäß der Erfindung; dazu zeigt

FIG 4 eine tristatefähige CMOS-Inverter- bzw. -Bufferstufe und ein ihr entsprechendes Schaltzeichen (Schaltungssymbol).

FIG 5 und FIG 6 zeigen weitere Beispiele tristatefähiger CMOS-Inverter- bzw. -Bufferstufen.

FIG 7 bis FIG 11 verdeutlichen Signalzustände in der Schaltung gemäß FIG 3.

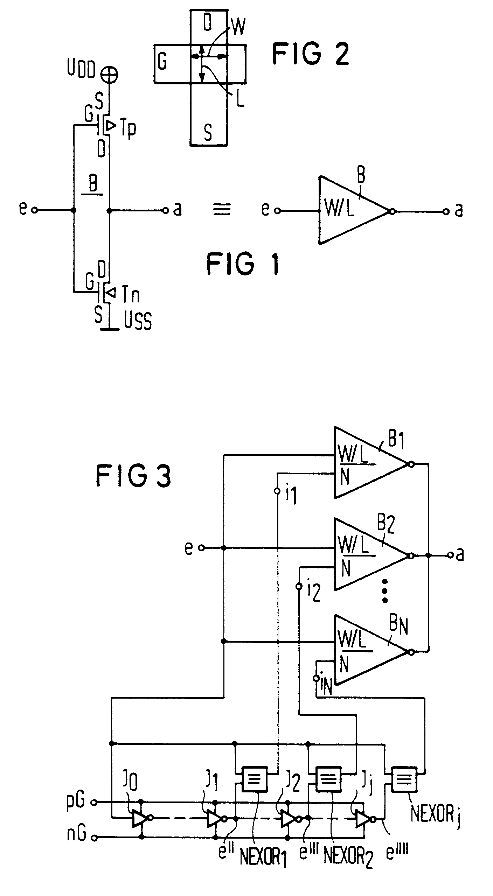

In FIG 1 ist in derem linken Teil eine konventionelle CMOS-Inverter- bzw.-Bufferschaltung B mit zwei miteinander in Reihe geschalteten, zueinander komplementären Feldeffekttransistoren Tp, Tn dargestellt, deren jeweils eine, der Reihenschaltung abgewandte Hauptelektrode (Source S) mit dem einen bzw. anderen Anschluß $U_{DD}$ bzw. $U_{SS}$ der Betriebsspannungsquelle verbunden ist; der Schaltungseingang e führt zu den miteinander verbundenen Steuerelektroden (Gate G) der beiden Transistoren Tp, Tn, deren miteinander verbundene andere Hauptelektroden (Drain D) zum Schaltungsausgang führen. Im rechten Teil der FIG 1 ist ein die im linken Teil der FIG 1 in schaltungstechnischen Einzelheiten umrissene Inverter- bzw. Bufferschaltung symbolisierender Schaltungsblock B dargestellt, wobei der in den Schaltungsblock B eingeschriebene Quotient W/L auf ein bestimmtes Verhältnis von Transistorkanalweite zu Transistorkanallänge der Komplementär-Transistoren TP, Tn hinweist.

Was damit gemeint ist, verdeutlicht die Darstellung in FIG 2, in der schematisch die gegenseitige Lage von Gate, Drain und Source eines Feldeffekttransistors skizziert und dazu dann angedeutet ist, was unter Transistorkanalweite W und Transistorkanallänge L zu verstehen ist. Der durch einen Transistor fließende Drain-Strom ist (u. a.) proportional dem Verhältnis W/L, wobei, wenn die beiden zueinander komplementären Transistoren Tp und Tn der Inverter-bzw. Bufferschaltung B gleich hohe Ströme schalten sollen, das beim p-Kanal-Transistor Tp erforderliche Verhältnis Wp/L von Transistorkanalweite zu Transistorkanallänge merklich größer als das beim n-Kanal-Transistor Tn erforderliche Verhältnis Wn/L ist.

Gemäß der Erfindung wird nun ein für eine vorgesehene Last erforderliches Verhältnis Wp/L bzw. Wn/L von Transistorkanalweite zu Transistorkanallänge der Komplementär-Transistoren (Tp, Tn in FIG 1) durch Parallelschaltung von N Inverter- bzw. Bufferschaltungen mit um den Faktor 1/N kleinerem Verhältnis von Transistorkanalweite zu Transistorkanallänge der Komplementär-Transistoren realisiert, wie dies im Beispiel in FIG 3 angedeutet ist. Die einander parallelgeschalteten N Inverter- bzw. Bufferschaltungen sind in FIG 3 mit $B_1$, $B_2$, $B_N$ bezeichnet; dazu ist angedeutet, daß die darin vorgesehenen Komplementär-Transistoren jeweils nur ein um den Faktor 1/N kleineres Verhältnis

$$\frac{W/L}{N}$$

von Transistorkanalweite zu Transistorkanallänge aufweisen, wobei wiederum beim p-Kanal-Transistor dieses Verhältnis

$$\frac{Wp/L}{N}$$

größer als das Verhältnis

$$\frac{Wn/L}{N}$$

beim n-Kanal-Transistor sein wird. Es kann beispielsweise, wie dies auch aus FIG 3 ersichtlich ist, N = 3 sein, womit sich, bezogen auf die Verhältnisse gemäß FIG 1 und FIG 2, die Transistorweiten jeweils auf $\frac{W}{3}$ reduzieren.

Wie in FIG3 weiter angedeutet ist, sind die N einander parallelgeschalteten Inverter- bzw. Bufferschaltung $B_1$,...,$B_N$ tristatefähig, d. h. sie sind jeweils von einem zusätzlichen Steuereingang i her zu sperren bzw. zu entriegeln.

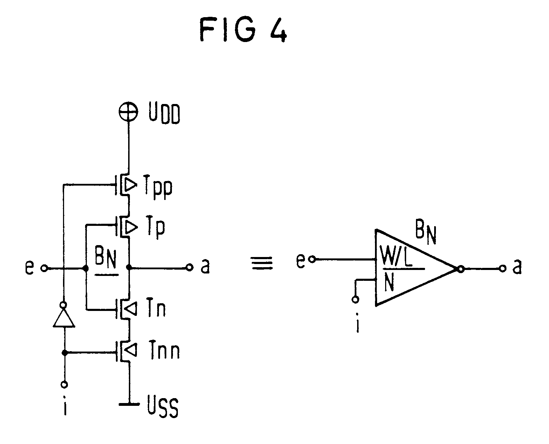

An dieser Stelle sei ein Blick auf FIG 4 geworfen, in derem rechten Teil das in FIG 3 verwendete Schaltungssymbol für eine tristatefähige CMOS-Inverter- bzw. -Bufferschaltung mit verkleinertem Verhältnis

$$\frac{W/L}{N}$$

von Transistorkanalweite zu Transistorkanallänge der Komplementär-Transistoren wiedergegeben ist; aus dem linken Teil der FIG 4 wird ersichtlich, daß eine solche tristatefähige Inverter- bzw. Bufferschaltung $B_N$ mit der Reihenschaltung zweier zueinander komplementärer Feldeffekttransistoren Tp, Tn in der Weise realisiert werden kann, daß jeweils zwischen Transistor (Tn bzw. Tp) (mit um den Faktor 2/N verringerter Transistorweite) und zugehörigen Speisepotentialanschluß ($U_{SS}$ bzw. $U_{DD}$) ein weiterer Transistor (Tnn bzw. Tpp) jeweils gleichen Kanaltyps und gleicher Transistorweite eingefügt ist, dessen Steuerelektrode mit einem zusätzlichen Steuereingang i verbunden ist.

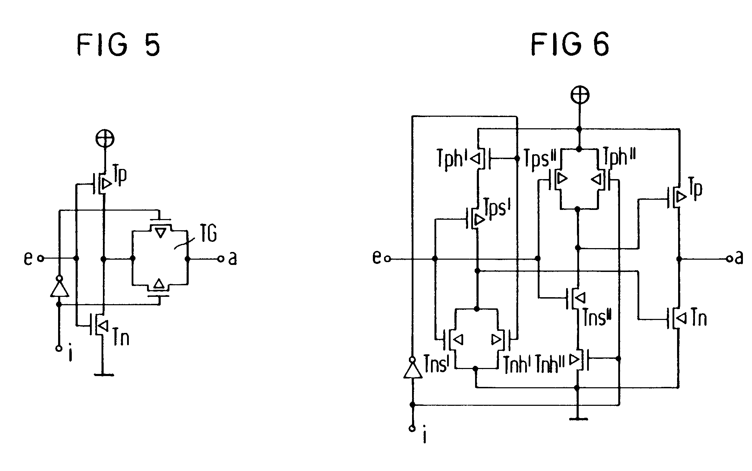

Weitere Realisierungsmöglichkeiten tristatefähiger CMOS-Inverter- bzw. -Bufferschaltungen zeigen FIG 5 und FIG 6: Gemäß FIG 5 ist der eigentlichen CMOS-Inverterschaltung Tp, Tn ein CMOS-Transfergate TG nachgeschaltet; gemäß FIG 6 liegt zwischen dem Schaltungseingang e und der Steuerelektrode des p-Kanal-Transistors Tp ein CMOS-NAND-Glied Tps", Tph", Tns", Tnh" und zwischen dem Schaltungseingang e und der Steuerelektrode des n-Signal-Transistors Tn ein CMOS-NOR-Glied Tps', Tph', Tns', Tnh'.

Es sei hier bemerkt, daß solche Schaltungskonfigurationen für sich (beispielsweise aus US-A-4 745 409, EP-B-0 219 848, US-A 4 746 921) bekannt sind.

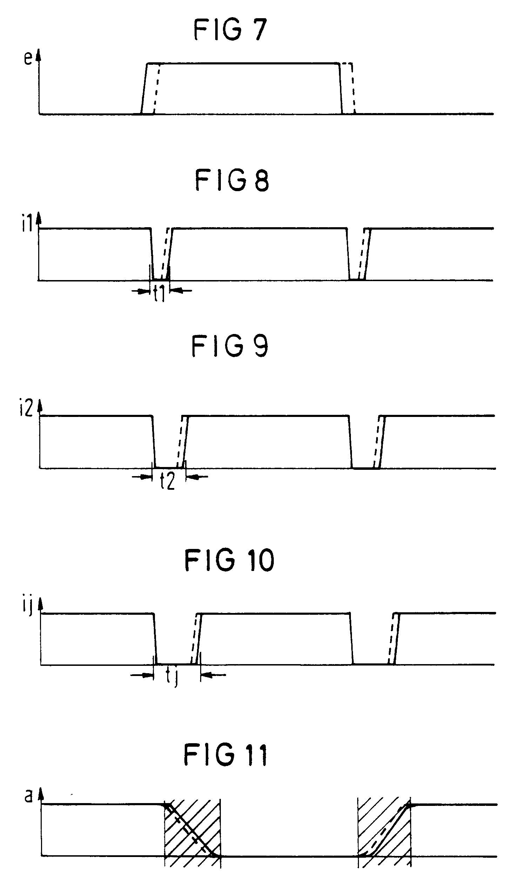

Um nun auf FIG 3 zurückzukommen, so sind in der dort skizzierten Schaltung gemäß der Erfindung die zusätzlichen Steuereingänge $i_1$, $i_s$,..., $i_N$ der N einander parallelgeschalteten tristatefähigen Inverter- bzw. Bufferschaltungen $B_1$, $B_2$,...,$B_N$ mit Abgriffen einer Laufzeit-Steuerkette verbunden, von der her die N Inverter- bzw. Bufferschaltungen $B_1$,...,$B_N$ bei jeder Zustandsänderung des am Schaltungseingang e auftretenden Signals unverzüglich kurzzeitig gesperrt und sukzessive wieder entriegelt werden. Wie dies auch aus FIG 3 ersichtlich ist, können dabei die zusätzlichen Steuereingänge i der Inverter- bzw. Bufferschaltung $B_1$,...,$B_N$ jeweils an ein Antivalenzglied EXOR oder Äquivalenzglied NEXOR angeschlossen sein, das mit seinem einen Eingang am Schaltungseingang e und mit seinem anderen Eingang an einem entsprechenden Abgriff einer eingangsseitig ebenfalls am Schaltungseingang e liegenden Laufzeitkette $J_0$, $J_1$, $J_2$,...$J_j$ liegt. Wie aus FIG 3 ersichtlich ist, kann die Laufzeitkette durch eine Kettenschaltung von CMOS-Invertern $J_0$,...,$J_j$ gebildet sein; diese CMOS-Inverter $J_0$,...,$J_j$ werden zweckmäßigerweise in an sich (etwa aus der US-A 3 791 326, Fig.7) bekannter Weise in ihrer Flankensteilheit geregelt bzw. gesteuert sein, was in der an sich bekannten Weise mit Hilfe von an ihren Gate-Elektroden mit entsprechenden Steuersignalen beaufschlagten zusätzlichen Transistoren im Speisestromkreis der CMOS-Inverter geschehen kann. In FIG 3 ist dazu angedeutet, daß den CMOS-Invertern $J_0$,.. ..,$J_j$ von Steuersignaleingängen pG, nG her entsprechende Steuersignale zugeführt werden.

Wie in FIG 3 auch angedeutet ist, können zwischen den einzelnen Abgriffen der Laufzeitkette $J_0$,...,$J_j$ ggf. auch mehrere CMOS-Inverter liegen, beispielsweise jeweils zwei derartige Inverter.

Je nachdem, ob das vom Schaltungseingang e herrührende Schaltungseingangssignal in der Laufzeitkette bis zu einem bestimmten Abgriff eine gerade oder eine ungerade Anzahl von Invertierungen erfahren hat, ist an dem betreffenden Anschluß ein Äquivalenzglied NEXOR oder ein Antivalenzglied EXOR angeschlossen.

Die im vorstehenden in ihrem schaltungstechnischen Aufbau erläuterte Schaltungsanordnung gemäß FIG 3 arbeitet dann wie folgt:

Sobald sich am Schaltungseingang e der Signalzustand ändert, d.h. bei einem 0-1 oder 1-0-Signalübergang des Schaltungseingangssignals (e in FIG 7), ist für alle an Abgriffe der Laufzeitkette $J_0$,$J_1$,$J_2$,...,$J_j$ liegenden Verknüpfungsglieder NEXOR$_1$, EXOR$_2$,...., NEXOR$_j$ die Koinzidenzbedingung nicht mehr erfüllt mit der unmittelbaren Folge, daß die an ihren Ausgängen auftretenden Signale (i1 in FIG 8, i2 in FIG 9, ij in FIG 10) in den 0-Zustand übergehen, so daß von den Steuereingängen $i_1$, $i_2$, ...,$i_N$ (in FIG 3) her die N einander parallelgeschalteten, tristatefähigen Inverter- bzw. Bufferschaltungen $B_1$,$B_2$,...,$B_N$ unverzüglich kurzzeitig gesperrt werden. Ist nach einer Zeitspanne t1 (in FIG 8) in der Laufzeitkette $J_0$,...,$J_j$ die Eingangssignal-Zustandsänderung bis zum ersten Abgriff e" der Laufzeitkette $J_0$,..., $J_j$ gelangt, so ist für das an diesen Abgriff der Laufzeitkette $J_0$,...,$J_j$ angeschlossene Verknüpfungsglied NEXOR$_1$ die Koinzidenzbedingung wieder erfüllt, so daß die erste Inverter- bzw. Bufferschaltung $B_1$ von ihrem zusätzlichen Steuereingang $i_1$ her wieder entriegelt wird.

Hat nach einer Zeitspanne t2 (in FIG 9) die Eingangssignal-Zustandsänderung den nächsten Abngriff e''' erreicht, so ist auch für das dort angeschlossene Verknüpfungsglied EXOR$_2$ die Koinzidenzbedingung wieder erfüllt, so daß jetzt auch die nächste Inverter- bzw. Bufferschaltung $B_2$ von ihrem zusätzlichen Steuereingang $i_2$ her entriegelt wird.

Hat schließlich nach einer Laufzeit tj (in FIG 10) die Eingangssignal-Zustandsänderung in der Laufzeitkette $J_0$,...,$J_j$ den letzten Abgriff e'''' erreicht, so ist auch für das daran angeschlossene letzte Verknüpfungsglied NEXOR$_j$ die Koinzidenzbedingung erfüllt mit der Folge, daß nunmehr auch die letzte Inverter- bzw. Bufferschaltung $B_N$ von ihrem zusätzlichen Steuereingang $i_N$ her wieder entriegelt wird.

Die sukzessive Entriegelung der N Inverter- bzw. Bufferschaltungen $B_1$,...,$B_N$ hat zur Folge, daß die der Zustandsänderung des Schaltungseingangssignals e (in FIG 7) entsprechende Flanke des Schaltungsausgangssignals a (in FIG 11) unabhängig von den Betriebsbedingungen annähernd gleichförmig und in einem auch bei Verlängerung oder Verkürzung um einen Laufzeitschritt praktisch gleichbleibenden Zeitraum gebildet wird. Dieser Zeitraum wird in FIG 11 durch eine Schraffur angedeutet; durch gestrichelte Flankenlinien wird in FIG 8 bis FIG 11 der Signalverlauf bei jeweils um einen Lauzeitschritt verkürzter Laufzeit angedeutet.

Es sei hier bemerkt, daß die Darstellung in FIG 3 nicht so zu verstehen ist, daß in der Laufzeit-Steuerkette stets mit einem Äquivalenzglied begonnen werden muß und daß Äquivalenzglieder und Antivalenzglieder stets abwechselnd aufeinanderfolgen müssen. Wie schon gesagt, hängt der Typ des an einen Abgriff anzuschließenden Verknüpfungsgliedes davon ab, ob das Schaltungseingangssignal in der Laufzeitkette bis zu dem betreffenden Abgriff hin eine ungeradzahlige oder geradzahlige Anzahl von Invertierungen erfahren hat. Liegen dabei zwischen zwei aufeinanderfolgenden Abgriffen beispielsweise zwei Inverter, so werden die an die beiden Abgriffe angeschlossenen Verknüpfungsglieder insoweit vom gleichen Typ sein.

Um die Sicherheit in der Vermeidung sämtlicher zwischen den Speisepotentialanschlüssen $U_{DD}$ und $U_{SS}$ fließenden Kurzschlußströme noch zu erhöhen, können die N einander parallelgeschalteten Inverter- bzw. Bufferschaltungen $B_1,...,B_N$ auch mit einem verzögerten Schaltungseingangssignal angesteuert werden, wie es in FIG 7 durch eine gepunktete Linie angedeutet ist.

Hierzu kann zwischen den Schaltungseingang e (in FIG 3) und die miteinander verbundenen Steuerelektroden der beiden Komplementär-Transistoren ($T_p$, $T_n$ in FIG 4, FIG 5, FIG 6) der einzelnen Inverter- bzw. Bufferschaltungen $B_1,...,B_N$ (in FIG 3) eine entsprechende Laufzeitschaltung eingefügt sein. Diese Laufzeitschaltung kann durch den ersten Teil der Laufzeitkette $J_0,...,J_j$ gebildet sein, was beispielsweise dadurch geschehen kann, daß in Abweichung von der Darstellung in FIG 3 die oberen Eingänge der N einander parallellgeschalteten Inverter- bzw. Bufferschaltung $B_1,...,B_N$ nicht direkt an den Schaltungseingang e angeschlossen werden, sondern an den Abgriff e'' der Laufzeitkette $J_0,...,J_j$. Eine solche Ausgestaltung der Erfindung kann insbesondere im Best-Case-Fall, d. h. bei steilen Flanken des am Schaltungseingang e (in FIG 3) auftretenden Schaltungseingangssignals (e in FIG 7) zweckmäßig sein.

**Patentansprüche**

1.  IC-Inverter- bzw. -Bufferschaltung in CMOS-Technologie mit der Reihenschaltung zweier zueinander komplementärer Feldeffekttransistoren ($T_p$, $T_n$), deren jeweils eine, der Reihenschaltung abgewandte Hauptelektrode mit dem einen bzw. anderen Anschluß ($U_{DD}$ bzw. $U_{SS}$) der Betriebsspannungsquelle verbunden ist, zu deren miteinander verbundenen Steuerelektroden der Schaltungseingang (e) führt und deren miteinander verbundene andere Hauptelektroden zum Schaltungsausgang (a) führen, **dadurch gekennzeichnet,**

daß ein für die vorgesehene Last erforderliches Verhältnis (Wp/L bzw. Wn/L) von Transistorkanalweite zu Transistorkanallänge der Komplementär-Transistoren ($T_p$, $T_n$) durch Parallelschaltung von N Inverter- bzw. Buffer-Schaltungen ($B_1,...,B_N$) mit um den Faktor 1/N kleinerem Verhältnis von Transistorkanalweite zu Transistorkanallänge der Komplementär-Transistoren ($T_p$, $T_n$) realisiert wird, daß in dieser Weise N tristatefähige Inverter- bzw. Buffer-Schaltungen ($B_1,...,B_N$) einander parallelgeschaltet sind, die jeweils von einem zusätzlichen Steuereingang (i) her zu sperrren bzw. zu entriegeln sind,

und daß die zusätzlichen Steuereingänge (i) dieser N tristatefähigen Inverter- bzw. Bufferschaltungen ($B_1,...,B_N$) mit Abgriffen einer Laufzeit-Steuerkette ($J_0;J_1,NEXOR_1;...;J_N,NEXOR_N$) verbunden sind, von der her die N Inverter- bzw. Buffer-Schaltungen ($B_1,...,B_N$) bei jeder Zustandsänderung des Schaltungseingangssignals (e) unverzüglich kurzzeitig gesperrt und sukzessive wieder entriegelt werden.

2.  Schaltung nach Anspruch 1,
    **dadurch gekennzeichnet,**
    daß die zusätzlichen Steuereingänge (i) der Inverter- bzw. Bufferschaltungen ($B_1,...,B_N$) jeweils an ein Antivalenzglied (EXOR) oder Äquivalenzglied (NEXOR) angeschlossen sind, das mit seinem einen Eingang an einem entsprechenden Abgriff einer eingangsseitig am Schaltungseingang (e) liegenden Laufzeitkette ($J_0,...,J_j$) und mit seinem anderen Eingang am Schaltungseingang (e) liegt.

3.  Schaltung nach Anspruch 2,
    **dadurch gekennzeichnet,**
    daß die Laufzeitkette durch eine Kettenschaltung von in ihrer Flankensteilheit geregelten CMOS-Invertern ($J_0,...,J_j$) gebildet ist.

4.  Schaltung nach einem der vorangehenden Ansprüche,
    **dadurch gekennzeichnet,**
    daß zwischen den Schaltungseingang (e) und die miteinander verbundenen Steuerelektroden der beiden Komplementär-Transistoren ($T_p$,$T_n$) der einzelnen Inverter- bzw. Bufferschaltungen ($B_1,..., B_N$) eine Laufzeitschaltung ($J_0$, $J_1$) eingefügt ist.

5.  Schaltung nach Anspruch 4 in Verbindung mit Anspruch 2 oder 3,
    **dadurch gekennzeichnet,**
    daß die Laufzeitschaltung durch den ersten Teil ($J_0$, $J_1$) der Laufzeitkette ($J_0,...,J_j$) gebildet

ist.

FIG 2

FIG 1

FIG 3

# FIG 4

FIG 6

FIG 5

# FIG 7

# FIG 8

# FIG 9

# FIG 10

# FIG 11

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 382 124 (NATIONAL SEMICONDUCTOR CORP.) <br> * Spalte 4, Zeile 21 - Spalte 6, Zeile 10; Abbildung 5 * <br> --- | 1-5 | H03K19/003 |
| Y | PATENT ABSTRACTS OF JAPAN <br> vol. 15, no. 139 (E-1053)9. April 1991 <br> & JP-A-3 019 424 ( MATSUSHITA ELECTRIC ) 28. Januar 1991 <br> * Zusammenfassung * <br> --- | 1-5 | |
| A | PATENT ABSTRACTS OF JAPAN <br> vol. 15, no. 330 (E-1103)22. August 1991 <br> & JP-A-3 124 119 ( FUJI ELECTRIC CO. ) 27. Mai 1991 <br> * Zusammenfassung * <br> --- | 1-5 | |
| A | PATENT ABSTRACTS OF JAPAN <br> vol. 14, no. 550 (E-1009)6. Dezember 1990 <br> & JP-A-2 235 435 ( NEC CORP. ) 18. September 1990 <br> * Zusammenfassung * <br> --- | 1-5 | RECHERCHIERTE SACHGEBIETE (Int. Cl.5) |
| A | EP-A-0 253 914 (DEUTSCHE ITT) <br> * das ganze Dokument * <br> ----- | 1 | H03K |

Der vorliegende Recherchenbericht wurde für alle Patentansprüche erstellt

| Recherchenort | Abschlußdatum der Recherche | Prüfer |
|---|---|---|
| DEN HAAG | 03 APRIL 1992 | FEUER F.S. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
...............................................................
& : Mitglied der gleichen Patentfamilie, übereinstimmendes
    Dokument

EPO FORM 1503 03.82 (P0403)